# EUROPEAN PATENT APPLICATION

(11) **EP 3 840 055 A1**
(43) Date of publication of application: **23.06.2021**
(21) Application number: 19217025.6
(22) Date of filing: 17.12.2019
(51) Int. Cl.: H01L 29/778, H01L 29/786, H01L 21/336, H01L 29/417, H01L 29/24, H01L 29/16

(54) **METHOD OF MANUFACTURING A MOSFET AND AN INTERMEDIATE STRUCTURE MANUFACTURED THEREBY**

(71) Applicant: Imec VZW, 3001 Leuven (BE)
(72) Inventor: Sutar, Surajit Kumar, 3001 Leuven (BE)
(74) Representative: Patent Department IMEC

(57) **Abstract**

The present disclosure relates to a method for manufacturing a field effect transistor comprising a source electrode (50) and a drain electrode (51) being in contact with a channel layer (31). The method comprises providing a substrate comprising a semiconductor layer (10), a layer of a first high-k dielectric material (41) overlying the channel layer, and the channel layer overlying the semiconductor layer, performing a patterning process such that at least the layer of the first high-k dielectric material is removed from a first region for forming a source electrode and from a second region for forming a drain electrode, so that a third region for forming a gate electrode is formed in between the first region and the second region, forming the source electrode in the first region and the drain electrode in the second region, wherein the source electrode and the drain electrode have exposed extremities and comprise a material susceptible to self-limiting oxidation, subjecting the source electrode and the drain electrode to an oxidizing medium, thereby converting the exposed extremities of the source electrode and the drain electrode into a conformal layer of an oxide (60), and providing the gate electrode (150) on the patterned layer of the first high-k dielectric material only in the third region.

## Description

### Technical Field of the Invention

The present invention relates to a method of manufacturing a field effect transistor (FET). More specifically, it relates to manufacturing a metal oxide semiconductor field effect transistor (MOSFET) and an intermediate structure manufactured thereby.

### Background Art

Reduction of device performance-limiting parasitic resistances and capacitances is an important consideration in designing and fabricating electronic devices.

In the context of MOSFETs, two of the primary device parasitics, the access resistance and the gate-source/drain capacitance, can be minimized by forming the source and drain regions in a self-aligned manner to the gate. This is possible in MOSFETs built on silicon and other mainstream semiconductor material dependent technologies through doping the source and drain contact regions self-aligned to the gate. However, no such capability exists for MOSFETs using different materials to make the channel layer, due to the lack of adequate doping techniques in these materials, such as 2D materials, or where the source/drain electrodes are directly placed on the channel, meaning that source drain electrodes are not separately doped contact regions as in Si MOSFETs, such as with III-V materials or with carbon nano tubes. Consequently, the device performance of such MOSFETs is limited by the access resistance and gate-source/drain capacitances.

Therefore, there is a need in the art for a method to realize MOSFETs with the source and drain regions being self-aligned to the gate.

### Summary of the Invention

It is an object of the present disclosure to provide methods for manufacturing field effect transistors (FETs) with gate electrode self-aligned to the source/drain regions; thus source/drain electrodes.

The above objective is accomplished by the method according to the present invention.

It is an advantage of embodiments of the present disclosure that the method allows for manufacturing FETs, with minimized access resistance and gate-source/drain capacitances.

It is an advantage of embodiments of the present disclosure that the method allows for manufacturing FETs having gate dielectric thicknesses below 10 nm, whereby the gate electrode is electrically isolated from the source/drain electrodes. It is further an advantage of embodiments of the present disclosure that the method allows for manufacturing FETs having gate dielectric thicknesses below 2 nm

It is an advantage of embodiments of the present disclosure that the method allows for providing a gate electrode self-aligned to the source/drain electrodes of a FET comprising a layer of a 2D material being the channel layer.

It is an advantage of embodiments of the present disclosure that the method allows for providing a gate electrode self-aligned to the source/drain electrodes of a FET comprising a layer of an III-V material being the channel layer.

It is an advantage of embodiments of the present disclosure that the method allows for providing a gate electrode self-aligned to the source/drain electrodes of a FET having gate dielectric thicknesses below 10 nm and comprising a layer of an III-V material, carbon nanotubes or a 2D material being the channel layer, whereby the gate electrode is electrically isolated from the source/drain electrodes.

In a first aspect, the present disclosure relates to a method for manufacturing a field effect transistor comprising a source electrode and a drain electrode being in contact with a channel layer. The method comprising:
- providing a substrate comprising a semiconductor layer, a layer of a first high-k dielectric material overlying the channel layer, and the channel layer overlying the semiconductor layer,
- performing a patterning process such that at least the layer of the first high-k dielectric material is removed from a first region for forming a source electrode and from a second region for forming a drain electrode, so that a third region for forming a gate electrode, comprising the patterned layer of the first high-k dielectric material, is formed in between the first region and the second region,
- forming the source electrode in the first region and the drain electrode in the second region, wherein the source electrode and the drain electrode have exposed extremities and comprise a material susceptible to self-limiting oxidation,
- subjecting the source electrode and the drain electrode to an oxidizing medium, thereby converting the exposed extremities of the source electrode and the drain electrode into a conformal layer of an oxide, and
- providing the gate electrode on the patterned layer of the first high-k dielectric material only in the third region.

In a second aspect, the present disclosure relates to an intermediate structure for manufacturing a field effect transistor. The intermediate structure comprising:
- a substrate comprising a first region spatially separated from a second region by a third region, the third region comprising a semiconductor layer, a channel layer overlying the semiconductor layer, and a layer of a first high-k dielectric material overlying the channel layer,
- a source electrode in the first region and a drain electrode in the second region, wherein the source electrode and the drain electrode are in contact with the channel layer and comprise a material susceptible to self-limiting oxidation and have a conformal layer of an oxide on their exposed extremities, and
- a first gate electrode on the layer of the first high-k dielectric material in the third region.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief Description of the Drawings

**Fig. 1a to Fig. 1f**: show schematic representations of process steps as used in an embodiment of the first aspect of the present invention.
**Fig.2****:** shows a schematic representation of an intermediate structure obtained during an embodiment according to the first aspect of the present invention, whereby the source electrode and the drain electrode has an upper portion and a lower portion and the extremities of the source electrode and the drain electrode are oxidized.
**Fig.3a to Fig. 3b**: show schematic representations of intermediate structures in an embodiment according to the first aspect of the present invention, whereby a void is formed in between the gate and the source electrode and in between the gate and the drain electrode.
**Fig. 3c****:** shows a schematic representation of an intermediate structure obtained during an embodiment according to the first aspect of the present invention, whereby a conformal layer of a layer of a dielectric material is provided on the extremities of the source electrode and the drain electrode.
**Fig.4a to Fig. 4c**: show a schematic representation of steps performed during an embodiment according to the first aspect of the present invention, whereby the substrate further comprises a layer of a second high-k dielectric material.
**Fig.5a to Fig. 5b**: show a schematic representation of steps performed during an embodiment according to the first aspect of the present invention showing the creation of the bottom gate electrode.
**Fig.6a to Fig. 6e**: show a schematic representation of steps performed during an embodiment according to the first aspect of the present invention showing an alternative for the creation of the bottom gate electrode.
**Fig. 7****:** show schematic representation of an intermediate structure for manufacturing a field effect transistor according to the second aspect of the present invention.
**Fig. 8a to Fig. 8b**: shows schematic representations of embodiments according to the second aspect of the present invention.

### Description of Illustrative Embodiments

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some, but not other features included in other embodiments, combinations of features of different embodiments are meant to be within the scope of the invention, and form different embodiments, as would be understood by those skilled in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures, and techniques have not been shown in detail in order not to obscure an understanding of this description.

The following terms are provided solely to aid in the understanding of the invention.

As used herein and unless provided otherwise, the term **"access *resistance"*** refers to the resistance due to the region of the channel between the edge of the source or drain contact electrode and the edge of the gate electrode.

As used herein and unless provided otherwise, the term ***"gate-source*/*drain* capacitance"** refers to the capacitance due to lateral or vertical overlap of the gate electrode with the source and drain electrodes.

As used herein and unless provided otherwise, the term ***"DC performance"*** refers to performance characteristics such as the total device resistance or on-state current or alike.

As used herein and unless provided otherwise, the term ***"high-frequency* performance"** refers to current and power gain, maximum current, and power gain cut-off frequencies. High frequency as used here refers to frequency values higher than 1GHz.

As used herein and unless provided otherwise, the term ***"two-dimensional material"*** refers to crystalline materials whose crystal structure is a two-dimensional array of atoms or molecules.

As used herein and unless provided otherwise, the term ***"self-limiting oxidation"*** refers to a process where the oxidation rate of a material at a given temperature and ambience drops to an infinitesimally small value after a certain thickness of the material has been oxidized.

The disclosure will now be described by a detailed description of several embodiments of the disclosure. It is clear that other embodiments of the disclosure can be configured according to the knowledge of persons skilled in the art without departing from the technical teaching of the disclosure, the disclosure being limited only by the terms of the appended claims.

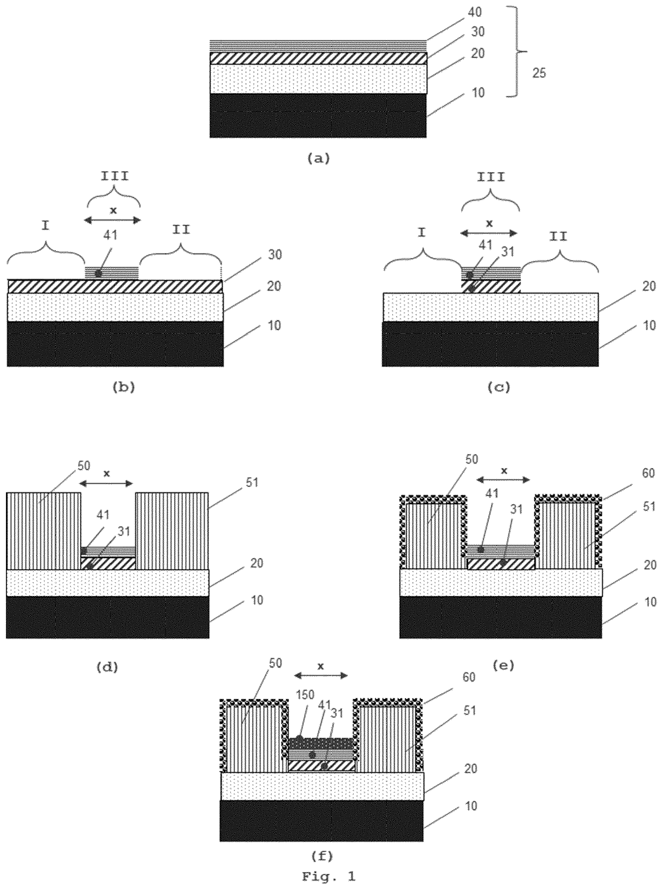

We now refer to **Fig. 1** showing a schematic representation of process steps as used in an embodiment of the first aspect of the present invention.

The method comprises providing a substrate (25). The substrate comprises a semiconductor layer (10). In embodiments, this semiconductor layer may be a Si layer. In embodiments, this Si layer may be a <111> oriented Si layer. In alternative embodiments, the semiconductor layer (10) may also be a Ge layer, SiC layer or an III-V semiconductor layer. The substrate (25) further comprises a layer of a first high-k dielectric material (40). This layer of the first high-k dielectric material (40) overlies a channel layer (30).

In embodiments, this layer of the first high-k dielectric material may be in direct contact with the channel layer (30).

In other embodiments, there may be an intermediate layer in between them in order to, for instance, enhance or facilitate the adhesion of the layer of the first high-k dielectric material (40) on the channel layer (30).

In embodiments, the layer of the first high-k dielectric material (40) may be any type of high-k dielectric material suitable for the manufacturing of field effect transistors as known in the art. The channel layer (30) overlies the semiconductor layer (10). In embodiments, the substrate may comprise a dielectric layer (20) in between the semiconductor layer (10) and the channel layer (30). This dielectric layer isolates the channel layer (30) from the semiconductor layer (10). Thus, it is prevented that the semiconductor layer (10) works as a parasitic parallel channel.

In embodiments, this dielectric layer (20) may be silicon oxide, when the semiconductor layer is a silicon layer. In alternative embodiments, this dielectric layer (20) may be a high band-gap material such as AlAs, AlN when the semiconductor layer is a III-V semiconductor layer. With respect to the thickness of this dielectric layer (20), the lower limit is determined by the leakage current and parasitic capacitance due to the dielectric; such that typically a thickness value of less than 5 nm is preferred. On the other hand, there is no upper limit for thickness barring feasibility and compatibility with the rest of the fabrication method.

In embodiments, the channel layer (30) may comprise a two-dimensional (2D) material. This two-dimensional material may be a transition metal dichalcogenide, which is denoted by the formula MX₂, where M denotes a transition metal such as for instance, W, Mo and X denotes a chalcogen, for instance, a non-metal of the oxygen group such as for instance, S, Se or Te. Graphene is another two-dimensional material. However, the fact that it does not have a band gap and the fact that measures to open up the band gap lead to a deterioration in its mobility poses challenges to its utilization as a channel layer.

In alternative embodiments, the channel layer (30) may comprise an III-V material.

In further alternative embodiments, the channel layer may comprise an II-VI material.

In embodiments, the thickness of the channel layer (30) may be less than 2 nm. This thickness is typically realized depending on the constraints induced by the synthesis method of the material. In practice, the upper limit for the thickness of the channel layer is less than 50 nm.

In further embodiments, the channel layer (30) may be made of carbon nanotubes. In these embodiments, the thickness of the channel layer maybe in the range of 0.3 nm to 40 nm.

The method further comprises performing a patterning process. As a result of this patterning process, at least the layer of the first high-k dielectric material (40) is removed from a first region (I) and from a second region (II) as for instance shown in **Fig. 1b****.** This leads to the formation of the patterned layer of the first high-k dielectric material (41). The first region (I) is suitable for forming a source electrode, while the second region (II) is suitable for forming a drain electrode. The patterning process thus, leads to the fact that a third region (III) having a width of "x" is formed that is suitable for forming a gate electrode. This third region (III) spatially separates the first region (I) from the second region (II) .

In embodiments, the layer of the first high-k dielectric material (40) and the channel layer (30) may both be removed from the first region (I) and from the second region (II) as, for instance, shown in **Fig. 1c****.**

The third region (III) having the width "x", in this case, comprises the patterned layer of the first high-k dielectric material (41) and the patterned channel layer (31). The method further comprises forming a source electrode (50) in the first region (I) and a drain electrode (51) in the second region (II) as for instance shown in **Fig. 1d****.** The source electrode (50) and the drain electrode (51) have exposed extremities and comprise a material susceptible to self-limiting oxidation. In embodiments, such material may be metals such as aluminum, titanium, copper. In alternative embodiments, such material may also be a semiconductor material such as silicon. The source electrode (50) and the drain electrode (51) are subjected to an oxidizing medium. Thanks to the self-limiting oxidation property, the source electrode and the drain electrode are not completely oxidized and the exposure converts the exposed extremities of the source electrode (50) and the drain electrode (51) into a conformal layer of an oxide (60) as for instance shown in **Fig. 1e****.** In this way, the width of the third region being the distance (x) between the source region and the drain region is preserved, since the thickness of the conformal layer of the oxide does not extend into the third region. Thus, the gate length still equals the distance (x) in between the source region (I) and the drain region (II).

In embodiments, the thickness of this conformal layer of oxide may configured such that it provides electrical isolation so that leakage current and breakdown voltages are obtained that are comparable to that of typical dielectrics used in the same device/technology.

In embodiments, the oxidizing medium may be a gaseous and/or a liquid medium. In preferred embodiments, the medium is a gaseous medium. In embodiments, this gaseous medium may be a gaseous ambient. In embodiments, the gaseous ambient comprises oxygen. This gaseous ambient may be the ambient that the source electrode and the drain electrodes are exposed to such as for instance inside a chamber of a process tool or inside a process environment. In embodiments, the substrate may, as a whole, be subjected to the oxidizing medium. The method further comprises providing the gate electrode (150) on the patterned layer of the first high-k dielectric material (41) in the third region (III) as for instance shown in **Fig. If.**

Provision of the gate electrode (150) may, in embodiments, be done in different ways.

In embodiments, this gate electrode (150) may be a metal or a semiconductor doped up to a concentration level of a dopant such that it achieves resistivities comparable to metals.

In embodiments, a dielectric layer may be deposited over the substrate after forming the source/drain electrodes (50, 51) and subjecting them to the oxidizing medium, thereby converting their extremities into the conformal layer of the oxide (60). This dielectric may, in embodiments, be silicon oxide. Performing a lithography process for gate electrode, using a photoresist layer defines the gate opening, which contains the third region (III) having the width "x". Gate electrode metal deposition may be followed by a planarization process, thereby forming a flat surface, whereby patterned photoresist features and the gate electrode metal abut a common surface. Etching back the gate electrode metal in the third region (III) leads to the formation of the gate electrode (150).

In alternative embodiments, provision of the gate electrode (150) may be facilitated through a lift-off process. This involves performing a lithography process, whereby a photoresist layer is deposited on the substrate followed by gate electrode patterning. Gate electrode metal is then provided on the substrate at the desired thickness, which is provided on the patterned photoresist features resting on the source/drain electrodes (50, 51) and on the exposed surfaces of the substrate. Following a gate metal lift-off process clears off the patterned photoresist features and gate electrode metal present on them.

The inventors have found out that in the manufacturing of the field effect transistors when the source electrode and the drain electrode comprise the material susceptible to self-limiting oxidation, the formation of the conformal layer of the oxide on the extremities of the source electrode and the drain electrode facilitates the making of the gate electrode self-aligned to the first region and the second region in which the source electrode and the drain electrode is formed, respectively.

Furthermore, due to this self-limiting property, no extra space is introduced within the third region, where the gate electrode is provided. Therefore, the gate length in the third region is preserved as compared to the design value. This is an advantage obtained compared to conventional practice, where dielectric spacers in between the source or the drain electrode and the gate electrode can be formed by deposition of dielectric layers followed by anisotropic etching. This reduces the gate length, thereby increasing access resistance. Thus, the method of the invention leads to an improvement in the DC performance and in the high-frequency performance of the FET. This is achieved by reducing the access resistance and the gate-source/drain capacitance.

It is also a further advantage that due to the self-limiting oxidation of the source electrode (50) and the drain electrode (51), there is no loss of gate length, which can thus, be made as small as lithography allows.

The method of the invention is particularly advantageous when the channel layer is made of a 2D material. Viable doping techniques for 2D materials do not exist. In absence of doped source region and doped drain region in FETs having channel layer of 2D materials, the channel length is the same as the distance between the source electrode and the drain electrode. Therefore, self-aligned gate and source/drain electrodes implies that the gate electrode length be the same as the source-drain electrode separation. This, then, introduces the challenge of electrical isolation of the gate electrode from the source electrode or the drain electrode. This becomes even more challenging as the thickness of the gate dielectric is scaled down.

With the method of the invention, electrical isolation can be obtained without the need to dope the layer of the 2D material, thanks to the source electrode or the drain electrode comprising the material susceptible to self-limiting oxidation that leads to the conversion into the conformal layer of the oxide as disclosed.

In embodiments, the patterning process may remove both the layer of the first high-k dielectric material (40) and the channel layer (30) as, for instance, shown in **Fig. 1c****.** The patterning process may comprise providing a patterned photoresist layer over the layer of the first high-k dielectric material (40) followed by etching the layer of the first high-k dielectric material (40) and the channel layer (30) from the first region (I) and from the second region (II), which are actually not covered by the patterned photoresist layer. In these embodiments, the duration of subjecting the source electrode (50) and the drain electrode (51) to the oxidizing medium is configured such that at least a portion of the source electrode (50) and the drain electrode (51), in direct contact with the channel layer (31), remains unoxidized. This provides that this at least unoxidized portion is in electrical contact with the patterned channel layer (31) so that the device can still function.

The thickness of the conformal layer (60) formed may differ as a function of time of subjecting the source/drain electrodes (50, 51) to the oxidizing medium depending on the type of different materials susceptible to self-limiting oxidation used. As the thickness of the gate dielectric (41) is scaling down, it becomes critical to configure the duration of this subjecting in order to avoid complete oxidation of the portion of the source electrode (50) or drain electrode (51) that is in direct contact with the patterned channel layer (31); otherwise the device will not function anymore since the current path through the source electrode/drain electrodes (50, 51) and the gate electrode (150) will be blocked by the conformal layer of the oxide formed. This may happen when, for instance, the thickness of the patterned gate dielectric is lower than the thickness of the conformal layer of the oxide (60) formed. If the subjection to the oxidizing medium is allowed to continue, for instance, until a maximum thickness achievable through the self-limiting oxidation nature of the source electrode (50) or the drain electrode (51) is obtained, the sidewall of the source/drain electrodes that is in contact with the first layer of high-k dielectric material and the channel layer may also be oxidized up to that maximum thickness, thereby blocking the electrical connection between the source/drain electrodes (50, 51) and the channel layer (31). This is due to the fact that there is also oxidation taking place in a downward direction in order to make up for the oxidation in the lateral direction. Therefore, in embodiments where the patterning process removes both the layer of the first high-k dielectric material (40) and the channel layer (30) from the first region (I) and from the second region (II), the extent of oxidation in a downward direction should be less than the combined thicknesses of the patterned layer of the first high-k dielectric material (41) and of the patterned channel layer (31) in order for the FET device to function.

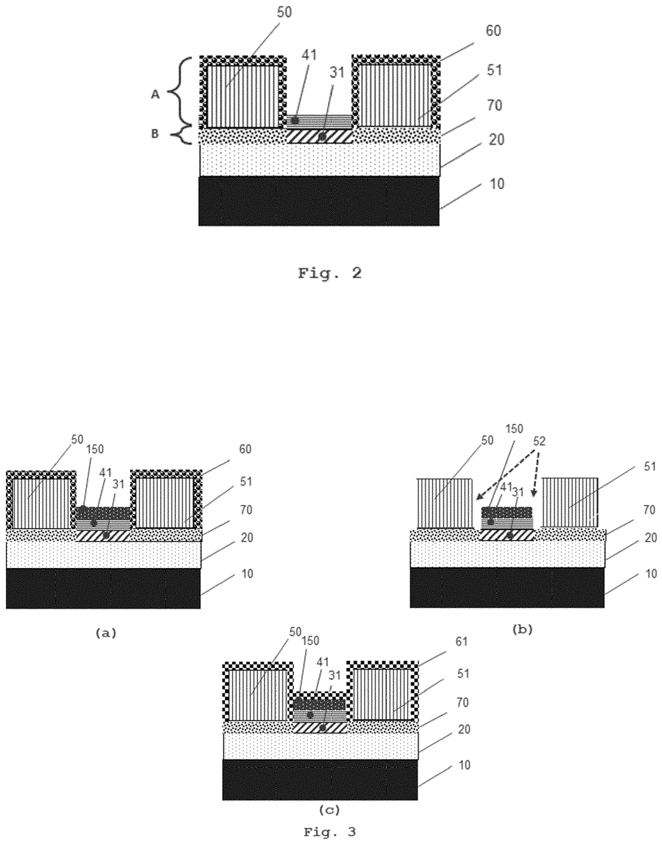

In embodiments, the material susceptible to self-limiting oxidation may be comprised in an upper portion **(A)** of the source electrode (50) and the drain electrode (51). The upper portion may be on and in contact with a lower portion **(B).** This lower portion may be in contact with the channel layer (31) and may comprise a material which is non-oxidizable by the oxidizing medium as shown, for instance, in **Fig. 2****.** In embodiments, the lower portion (B) may have a thickness at least equal to the thickness of the patterned channel layer (31). It is advantageous that the material of the lower portion is not oxidizable by the oxidizing medium since having it oxidized would then cut the electrical connection between the source/drain electrodes (50, 51) and the channel layer (31). In these embodiments, even though there is loss of the length of the source electrode and drain electrode due to oxidation of their surface, it does not pose a constraint on how small the electrode lengths can be made.

In embodiments, where the thickness of this lower portion **(B)** is not as high as the thickness of the channel layer (31) poses no problem on the functioning of the device even the complete sidewall of the source/drain electrodes that are in contact with the layer of the first high-k dielectric material and the channel layer would be oxidized. This is because there will always be an electrical connection in between the source/drain electrodes (50, 51) and the channel layer (31) thanks to this lower portion **(B)** comprising the material that is not oxidizable by the oxidizing medium.

In embodiments, where the channel layer is not patterned (30) as, for instance, in **Fig. 1b****,** then the lower portion is in contact with the channel layer horizontally. In these embodiments, the thickness of the lower portion (B) needs to be less than the thickness of the patterned layer of the first high-k dielectric material (41).

While in embodiments, where the channel layer is patterned (31) as shown, for instance, in **Fig. 1c****,** then the lower portion will be in contact with the patterned channel layer (31) vertically from the side walls of the patterned channel layer (31). In these embodiments, the thickness of the lower portion (B) needs to be less than the sum of the thickness of the patterned layer of the first high-k dielectric material (41) and the patterned channel layer (31).

It is advantageous to have such a lower portion **(B)** comprised in the source electrode (50) or the drain electrode (51). This makes it possible for the channel layer, being patterned (31) as in **Fig. 1c** or not patterned as in **Fig. 1b****,** to always have electrical contact with the source electrode (50) or the drain electrode (51). In embodiments, where the channel layer (30) is not patterned as in **Fig. 1b****,** it is further advantageous since this makes the thickness of the conformal layer of the oxide become independent of the thickness of the patterned layer of the first high-k dielectric material (41).

In embodiments, the thickness of the lower portion may have a thickness at least equal to or lower than or higher than the thickness of the patterned channel layer (31). In embodiments, however, even where the thickness of the lower portion is lower than the thickness of the channel layer, the extend of self-limiting oxidation of the extremities of the source/drain electrodes (50, 51) becomes independent of the thickness of the layer of the first high-k dielectric material (41) such that oxidation along the sidewall of the source/drain electrode that is in contact with the channel layer (31) poses no problem.

In embodiments, the method may further comprise removing the conformal layer of the oxide (60) from the source electrode (50) and from the drain electrode (51) after forming the gate electrode (150). This forms thereby a void (52) in between the gate electrode (150) and the source electrode (50) and in between the gate electrode (150) and the drain electrode (51) as for instance shown in **Fig. 3a and 3b****.** It is advantageous to remove the oxide layer (60) in situations where the dielectric quality of the oxide (60) is such that it's electrical resistance, capacitance and breakdown characteristics do not comply with the FET device specifications. In embodiments, the void creates an air gap thus, as such, offering alternatively better electrical resistance, capacitance and breakdown characteristics for the FET device. Removal of this conformal layer of oxide (60) may be done by etching that would be selective to the conformal layer of oxide with respect to the gate electrode (150). By selective, it thus, means that during the removal of the conformal layer of oxide, gate electrode (150) is not removed. Furthermore, the etching process parameters have to be configured such that any part of the substrate being exposed as a result of the etching process remains intact and not further etched so that a conformal void is created in place of the conformal layer of the oxide (60).

In further embodiments, the method may comprise providing a layer of a dielectric material (61) on the source electrode (50) and on the drain electrode (51) at a thickness such that the void (52) is completely filled. In embodiments, this layer of the dielectric material (61) maybe a conformal layer and thus, also covering the gate electrode (150) as for instance, shown in **Fig. 3c****.** As such, the provision of the conformal layer of the dielectric material (61) may be done, for instance, by an atomic layer deposition (ALD) process. This layer of the dielectric material (61) may be chosen such that it provides preferred electrical resistance, capacitance and breakdown characteristics for the FET device. Choosing this layer of the dielectric material as a low-k dielectric material has the advantage that it leads to a reduction in the gate-source/drain capacitance.

The method disclosed in the foregoing embodiments makes it possible to manufacture a FET device having a top gate electrode (150) self-aligned to the source electrode (50) and the drain electrode (51). Further embodiments of the method disclosed allow for manufacturing a FET comprising a dual gate self-aligned to the source electrode (50) and the drain electrode (51).

Thus, in embodiments, the substrate (25) may further comprise a layer of a second high-k dielectric material (90) sandwiched in between the channel layer (30) and a layer of an oxidizable, conductive material (80). The method may then further comprise, after performing the patterning process, replacing the portions of the layer of the oxidizable, conductive material in the first region (I) and in the second region (II) by a dielectric layer (85). A portion (86) of the layer of the oxidizable, conductive material (80) remains in the third region (III). This portion (86) of the oxidizable, conductive material (80) remaining in the third region (III) thus, forms another gate electrode (86), wherein the thickness of the dielectric layer (85), in the first region (I) and in the second region (II), is at least the same as the thickness of the portion (86) of the layer of the oxidizable, conductive material in the third region (III). It is an advantage in these embodiments that a bottom gate electrode (86) is formed. This makes it possible to manufacture a dual gate FET with self-aligned gate electrode, which has improved DC performance and high frequency performance thanks to the reduced access resistance and gate-source/drain capacitance.

In embodiments, the layer of the oxidizable, conductive material (80), for instance, may be, but is not limited to aluminum, molybdenum or titanium.

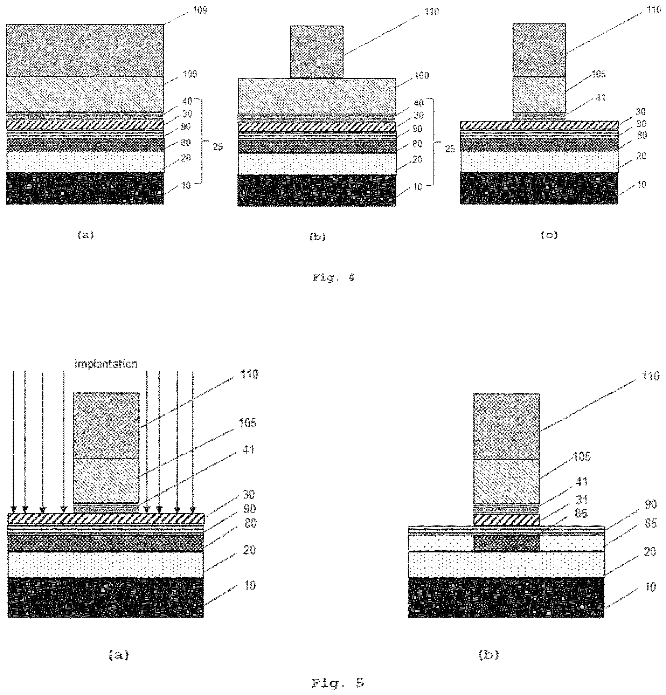

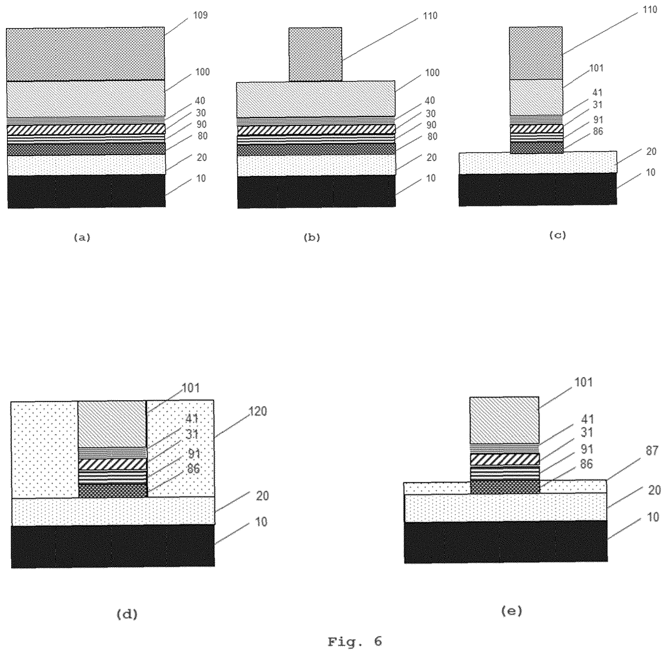

In any embodiments, the patterning process may comprise providing a layer stack for patterning on the substrate. This layer stack comprises at least a photoresist layer (109) as shown, for instance, in **Fig. 4a****.** A patterned layer stack is formed on the substrate corresponding to the third region (III) as shown, for instance in **Fig. 4b** and **Fig. 6b****.** Substrate is further etched using the patterned layer stack as a mask as shown, for instance, in **Fig. 4c** and **6c****.**

In embodiments, the layer stack may also comprise a sacrificial layer (100) in between the layer of the first high-k dielectric material (40) and the photoresist layer (109) shown, for instance, as in **Fig. 4a****.** Performing a lithography process leads to the formation of a patterned photoresist layer (110) as shown, for instance, in **Fig. 4b****.** Etching the sacrificial layer (100) and the layer of the first high-k dielectric (40) using the patterned photoresist layer (110) as a mask leads to the formation of the patterned sacrificial layer (105) and patterned layer of the first high-k dielectric material (41).

In these embodiments, the replacement may comprise performing an oxygen implantation process through the channel layer (30) and through the layer of the second high-k dielectric material (90) as shown, for instance in **Fig. 5a****.** This implantation process provides area selective oxidation of the layer of the oxidizable, conductive material (80) in the first region (I) and in the second region (II) thus oxidizing it, while in the third region (III), it remains unoxidized (86) since it is masked by the patterned layer of the first high-k dielectric material (41) and by the patterned sacrificial layer (105) and patterned photoresist layer (110), which make up the patterned layer stack. Thus, the risk of oxidizing the complete layer of the oxidizable, conductive material is avoided, which would otherwise result in the bottom gate electrode (86) to disappear.

In embodiments, the layer of the sacrificial layer (100) may be etched selectively with respect to the layer of the first high-k dielectric material (40). In such embodiments, both the patterned photoresist layer (110) and the patterned sacrificial layer (105) then, can make up for the patterned layer stack and can be used as a mask to etch the first layer of the high-k dielectric material (40) and/or further layers of the substrate.

In other embodiments, where selectivity with respect to the first layer of the high-k dielectric material is not needed, patterned photoresist layer (110) makes up for the patterned layer stack and can be used a mask to etch the layer of the first high-k dielectric material (40) and/or further layers of the substrate.

In embodiments, the layer of the first high-k dielectric material is removed from the first region (I) and from the second region (II) by performing this patterning process, thereby forming a patterned layer of a first high-k dielectric layer (41) in the third region (III) as shown, for instance, in **Fig. 4c****.**

Following the oxygen implantation process, an annealing process may be performed in order to cure for the defects created as a result of implantation and to better distribute the oxygen dopants. Afterwards, the channel layer (30) may be removed from the first region (I) and from the second region (II), as shown for instance, in **Fig. 5b****.** This is due to the fact that the portions of the channel layer in the first region (I) and in the second region (II) that have been subjected to the implantation process cannot be used to function as a channel layer anymore since it is damaged due to the implantation process. The unoxidized portion (86) of the layer of the oxidizable, conductive material (80) in the third region (III), thus make up the bottom gate electrode (86).

In alternative embodiments, the layer of the first high-k dielectric material (40), the channel layer (30), the layer of the second high-k dielectric material (90) and the layer of the oxidizable, conductive material (80) may be removed from the first region (I) and from the second region (II) by performing the patterning process as shown, for instance in **Fig. 6b****.** The patterning process used in these embodiments may comprise providing a layer stack comprising a sacrificial layer (100) in between the layer of the first high-k dielectric material (40) and the photoresist layer (109) shown, for instance, as in **Fig. 6a****.** Following a lithography process, a patterned photoresist layer (110) is formed as shown, for instance in, in **Fig. 6b****.** Etching through the layer of the first high-k dielectric material (40), the channel layer (30), the layer of the second high-k dielectric material (90) and the layer of the oxidizable, conductive material (80) using the patterned photoresist layer (110) as a mask results in the formation of the patterned features (101, 41, 31, 91, 86) as, for instance, shown in **Fig. 6c****.**

The replacement process, in these embodiments, may comprise providing a layer of a dielectric material (120) over the substrate. Performing a planarization process results in removing the overburden of the layer of the dielectric material (120) as shown, for instance, in **Fig. 6d****.** so that an upper surface of the patterned sacrificial layer (101) and of the layer of the dielectric material (120) abut a common plane. This may be followed by removing the layer of the dielectric material (120) from the first region (I) and from the second region (II) to an extent such that the thickness of the layer of the remaining dielectric material (85) in the first region (I) and in the second region (II) is at least the same as the thickness of the portion of layer of the oxidizable, conductive material (86) in the third region (III) (see Fig. 6e). This removal process may be referred to as an etch-back process and it could be a time dependent process. This layer of the oxidizable, conductive material in the third region (III) then forms the bottom gate electrode.

In embodiments, the sacrificial layer (100) may be any material that can be etched selectively with respect to the layer of the first high-k dielectric layer (40) and the layer of the dielectric material (120). In these embodiments, the sacrificial material may be, for instance, W, Ti, TiN or materials suitable for being a hard mask, such as for instance, spin-on carbon. It is also an advantage that the sacrificial layer (100) is etched easily compared to the layer of the first high-k dielectric layer (40) and the layer of the dielectric material (120).

In embodiments, the layer of the dielectric material (120) may be silicon oxide.

In embodiments, wherein the patterning stack consists of a photoresist layer (109) on and in contact with the sacrificial layer (100), forming the source electrode (50) and the drain electrode (51) may comprise providing a metal for source electrode (50) or for drain electrode (51) over the substrate. This provision may be done in terms of a metal deposition process. In these embodiments, the metal may be provided after removing the patterned photoresist layer (110) from the substrate. Performing a planarization process, thereby makes an upper surface of the patterned sacrificial layer (101) co-planar with an upper surface of the source electrode (50) and with an upper surface of the drain electrode (51). Removing the patterned sacrificial layer from the third region (III) exposes an upper surface of the first high-k dielectric material. The metal for the source electrode (50) and the drain electrode (51) may be any suitable metal for that purpose. The source electrode and the drain electrode may further be doped with an effort to reduce contact resistance. The doping can be performed if silicon is used as the source/drain electrode (50, 51).

In alternative embodiments, the provision of the metal for the source electrode (50) and the drain electrode (51) may be done while the patterned photoresist layer is still present. The metal may then be deposited on the first region (I) and on the second region (II) as well as on the patterned photoresist layer (110), which is in the third region (III). The provision of the metal may be configured such that a desired thickness is obtained for the source electrode and the drain electrode. A lift-off process may then be performed that removes the patterned photoresist layer (110) together with the metal on top of it, from the third region (III).

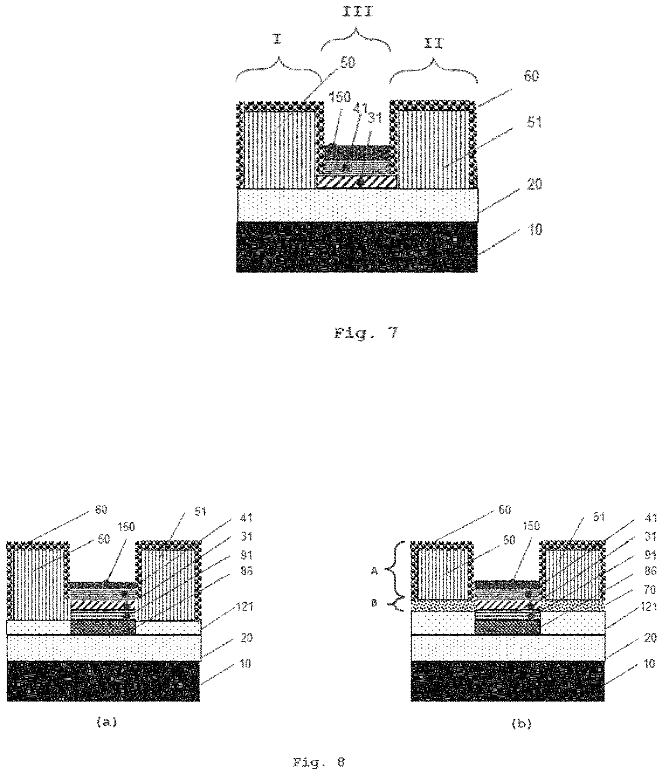

We now refer to **Fig. 7** showing a schematic representation of the intermediate structure as used in an embodiment of the second aspect of the present invention.

This intermediate structure for manufacturing a field effect transistor comprises a substrate (25). This substrate comprises a first region (I) spatially separated from a second region (II) by a third region (III). This third region (III) comprises a semiconductor layer (10), a channel layer (31) overlying the semiconductor layer, and a layer of a first high-k dielectric material (41) overlying the channel layer (31). It further comprises a source electrode (50) in the first region (I) and a drain electrode (51) in the second region (II), wherein the source electrode (50) and the drain electrode (51) are in contact with the channel layer (31) and comprise a material susceptible to self-limiting oxidation and have a conformal layer of an oxide on their exposed extremities as shown, for instance, in Fig. 7. The intermediate structure further comprises a first gate electrode (150) on the layer of the first high-k dielectric material (41) in the third region (III) as shown, for instance, in **Fig. 7****.**

Such an intermediate structure is advantageous since it allows for manufacturing a field effect transistor, whereby the gate electrode is self-aligned to the source electrode and drain electrode. It is further advantageous to use such an intermediate structure when a channel layer would be used, whereby the source and drain regions associated with that channel layer are not capable of being doped. The device performance of the FET device to be made using such an intermediate structure, such as the DC performance and the high-frequency performance, would then be limited by the access resistance and the gate-source/drain capacitances.

In embodiments, the channel layer may be of a two-dimensional material. In these embodiments, the intermediate structure is further advantageous since it allows for manufacturing a field effect transistor, whereby the DC performance and the high-frequency performance of the device will not be limited by the access resistance and gate-source/drain capacitances. Without the intermediate structure of the present invention, this would pose a drawback in the manufacturing of FETs employing two-dimensional materials as channel layer since capabilities for doping of the source region and the drain region are almost non-existent if not limited, that could help to implement gate electrode self-aligned to the source electrode and drain electrode.

This two-dimensional material may be a transition metal dichalcogenide, which is denoted by the formula MX₂, where M denotes a transition metal such as for instance, W, Mo and X denotes a chalcogen, for instance, a non-metal of the oxygen group such as for instance, S, Se or Te. Graphene is another two-dimensional material.

In embodiments, the conformal layer of the oxide (60) may be an oxide obtainable by oxidation of the material susceptible to self-limiting oxidation, which is comprised in the source/drain electrodes (50, 51). This is an advantage such that the channel length predicted by the design and defined by the source region and the drain region of this intermediate structure is preserved. By design, it is meant the original design made in the mask set. Therefore, no extra space is present in the channel of the FET device to be made using this intermediate structure. Such extra space in the channel, which reflects itself as a difference between the design and the final device obtained, would increase the FET access resistance.

In embodiments, the substrate may further comprise a layer of a second high-k dielectric material (91). This layer of the second high-k dielectric material may be sandwiched in between the channel layer (31) and a portion of an oxidizable, conductive material (86) in the third region (III). The portion of the oxidizable, conductive material (86) may laterally be sandwiched by a dielectric layer (121) being in the first region (I) and in the second region (II). The dielectric layer (121) may have a thickness being at least the same as the thickness of the portion of the layer of the oxidizable conductive material (86) in the third region (III) as shown, for instance, in **Fig 8a****.** In these embodiments, the portion of an oxidizable, conductive material (86) in the third region (III) acts as a bottom gate electrode of a FET device to be made using this intermediate structure.

This dielectric layer (121) acts as an insulating layer between the source/drain electrodes (50, 51) and the bottom gate electrode (86) so that the bottom gate electrode (86) is not shorted by the source/drain electrodes (50, 51).

In embodiments, the dielectric layer (121) that is laterally sandwiching the portion of the oxidizable, conductive material (86) may be any kind of dielectric material. In preferred embodiments, this dielectric layer (121) may be a low-k dielectric material. This has the advantage that the parasitic capacitance between the source/drain electrode and the bottom gate electrode (86) is reduced. This also leads to a reduction in leakage current.

In alternative embodiments, this dielectric layer (121) may be an oxide of the oxidizable conductive material (86) that is in the third region (III). This oxide (121) may, in embodiments, be for instance, an oxide of aluminum, molybdenum or titanium, which can be used as the oxidizable, conductive material (80).

In embodiments, the material susceptible to self-limiting oxidation may be comprised in an upper portion **(A)** of the source electrode (50) and the drain electrode (51). This upper portion **(A)** may be on and in contact with a lower portion **(B)** comprising a non-oxidizable material and being in contact with the channel layer (31) along its thickness, as shown, for instance in **Fig. 8b****.** The fact that this lower portion **(B)** is in contact with the channel layer (31), allows the channel to be in electrical contact with the source/drain electrodes (50, 51). The thickness of the dielectric layer (121) in these embodiments may be configured such that it laterally sandwiches both the portion of the oxidizable, conductive material (86) in the third region (III) and the layer of the second high-k dielectric material (91) that overlays it. In these embodiments, the thickness of the dielectric layer (121) may not be such that it also laterally sandwiches the channel layer (31) since in that case there would be no more electrical contact between the source/drain electrodes (50, 51) and the channel layer (31).

## Claims

1. Method for manufacturing a field effect transistor comprising a source electrode and a drain electrode being in contact with a channel layer, the method comprising:
- providing a substrate (25) comprising a semiconductor layer (10), a layer of a first high-k dielectric material (40) overlying the channel layer (30), and the channel layer (30) overlying the semiconductor layer (10),
- performing a patterning process such that at least the layer of the first high-k dielectric material (40) is removed from a first region (I) for forming a source electrode and from a second region (II) for forming a drain electrode, so that a third region (III) for forming a gate electrode, comprising the patterned layer of the first high-k dielectric material, is formed in between the first region (I) and the second region (II),
- forming the source electrode (50) in the first region (I) and the drain electrode (51) in the second region (II), wherein the source electrode (50) and the drain electrode (51) have exposed extremities and comprise a material susceptible to self-limiting oxidation,
- subjecting the source electrode (50) and the drain electrode (51) to an oxidizing medium, thereby converting the exposed extremities of the source electrode and the drain electrode into a conformal layer of an oxide (60), and
- providing the gate electrode (150) on the patterned layer of the first high-k dielectric material (41) only in the third region (III).

2. The method according to claim 1, wherein the patterning process removes both the layer of the first high-k dielectric material (40) and the channel layer (30) from the first region (I) and from the second region (II) and wherein the duration of subjecting the source electrode and the drain electrode to the oxidizing medium is configured such that at least a portion of the source electrode and the drain electrode, in direct contact with the patterned channel layer (31), remains unoxidized, so that the unoxidized portion is in electrical contact with the patterned channel layer.

3. The method according to claim 1 or claim 2, wherein the material susceptible to self-limiting oxidation is comprised in an upper portion (A) of the source electrode (50) and the drain electrode (51), the upper portion (A) being on and in contact with a lower portion (B) of the source electrode (50) and the drain electrode (51), the lower portion:
a. being in electrical contact with the channel layer (31),
b. comprising a material non-oxidizable by the oxidizing medium.

4. The method according to any one of the previous claims, wherein the method further comprises:
- removing the conformal layer of the oxide (60) from the source electrode (50) and from the drain electrode (51) after forming the gate electrode (150), thereby forming a void (52) in between the gate electrode (150) and the source electrode (50) and in between the gate electrode (150) and the drain electrode (51).

5. The method according to claim 4, wherein the method further comprises providing a layer of a dielectric material (61) on the source electrode (50) and on the drain electrode (51) at a thickness such that the void (52) is completely filled.

6. The method according to any one of the previous claims, wherein the substrate (25) further comprises a layer of a second high-k dielectric material (90) sandwiched in between the channel layer (30) and a layer of an oxidizable, conductive material (80), wherein the method further comprises, after performing the patterning process, replacing portions of the layer of the oxidizable, conductive material in the first region (I) and in the second region (II) by a dielectric layer (85, 87), whereby a portion of the layer of the oxidizable, conductive material (86) remains in the third region (iii), thereby forming another gate electrode and wherein the thickness of the dielectric layer (85, 87), in the first region (I) and in the second region (II), is at least the same as the thickness of the portion of the layer of the oxidizable, conductive material (86) in the third region (III).

7. The method according to claim 6, wherein the layer of the first high-k dielectric material (40) is removed from the first region (I) and from the second region (II) by performing the patterning process and the replacement comprises:
- performing an oxygen implantation process through the channel layer (30) and the layer of the second high-k dielectric material (90) and thereafter,
- performing an annealing process, and
- removing the channel layer (30) from the first region (I) and from the second region (II).

8. The method according to claim 6, wherein the layer of the first high-k dielectric material (40), the channel layer (30), the layer of the second high-k dielectric material (90) and the layer of the oxidizable, conductive material (80) are removed from the first region (I) and from the second region (II) by performing the patterning process and the replacement comprises:
- providing a layer of a dielectric material (120) over the substrate (25),
- performing a planarization process,
- removing the layer of the dielectric material (120) in the first region (I) and in the second region (II) to an extent such that the thickness of the layer of the remaining dielectric material (87) in the first region (I) and in the second region (II) is at least the same as the thickness of the layer of the oxidizable, conductive material (86) in the third region (III).

9. The method according to any one of the previous claims, wherein performing the patterning process comprises:
- providing, on the substrate (25), a layer stack for patterning comprising at least a photoresist layer,
- forming a patterned layer stack on the third region (III), and
- etching the substrate using the patterned layer stack as a mask.

10. The method according to claim 9, wherein the layer stack for patterning consists of a photoresist layer (109) on and in contact with a sacrificial layer (100), and forming the source electrode (50) in the first region (I) and the drain electrode (51) in the second region (II) comprises:
- providing a metal for source electrode or for drain electrode over the substrate,
- performing a planarization process, thereby making an upper surface of the patterned sacrificial layer co-planar with an upper surface of the source electrode and with an upper surface of the drain electrode,
- removing the patterned sacrificial layer from the third region, thereby exposing an upper surface of the first high-k dielectric material.

11. The method according to any one of claims 1 to 10, wherein the channel layer (30) comprises a two-dimensional material.

12. An intermediate structure for manufacturing a field effect transistor, the intermediate structure comprising:
- a substrate comprising a first region (I) spatially separated from a second region (II) by a third region (III), the third region comprising a semiconductor layer (10), a channel layer (31) overlying the semiconductor layer, and a layer of a first high-k dielectric material (41) overlying the channel layer,
- a source electrode (50) in the first region and a drain electrode (51) in the second region, wherein the source electrode and the drain electrode are in contact with the channel layer (31) and comprise a material susceptible to self-limiting oxidation and have a conformal layer of an oxide (60) on their exposed extremities, and
- a first gate electrode (150) on the layer of the first high-k dielectric material (41) in the third region (III).

13. The intermediate structure according to claim 12, wherein the conformal layer of the oxide (60) is an oxide obtainable by oxidation of the material susceptible to self-limiting oxidation.

14. The intermediate structure according to claim 12 or 13 wherein the substrate further comprises a layer of a second high-k dielectric material (91) sandwiched in between the channel layer (31) and a portion of an oxidizable, conductive material (86) in the third region (III), wherein the portion of the oxidizable, conductive material (86) is laterally sandwiched by a dielectric layer (121) being in the first region (I) and in the second region (II), wherein the dielectric layer (121) has a thickness being at least the same as the thickness of the portion of the layer of the oxidizable conductive material (86) in the third region (III).

15. The intermediate structure according to any one of claims 12 to 14, wherein the material susceptible to self-limiting oxidation is comprised in an upper portion (A) of the source electrode (50) and the drain electrode (51), the upper portion (A) being on and in contact with a lower portion (B) comprising a non-oxidizable material and being in contact with the channel layer (31) along its thickness.
